# EUROPEAN PATENT APPLICATION

(11) **EP 0 557 052 A2**
(43) Date of publication of application: **25.08.1993**
(21) Application number: 93301108.2
(22) Date of filing: 16.02.1993
(51) Int. Cl.: H03M 1/34

(54) **Analog to digital converter**

(30) Priority: 19.02.1992 US 839536
(71) Applicant: Hewlett-Packard Company, Palo Alto, California 94304 (US)
(72) Inventor: Jewett,Robert E., Redwood City,California 94061 (US)
(74) Representative: Williams, John Francis

(57) **Abstract**

Improvements in quantizer circuits and amplifier circuits for use in multistep flash analog to digital converters. A quantizer circuit of the present invention provides an analog to digital converter with an improved linear response near a center point of an allowed input range of the converter. A particular embodiment of the quantizer circuit includes a multithreshold differential comparator having improved response time while providing dynamically variable threshold levels. A novel linearization method for the improved multistep flash analog to digital converter is disclosed.

## Description

The present invention relates to improvements in multistep flash analog to digital converters. More specifically the present invention relates to improvements in quantizer circuits and amplifier circuits used in multistep flash analog to digital converters.

Various multistep flash analog to digital converters have been known for a number of years, and by way of example a form of such a device can be found in U.S. Patent No. 3,425,054 issued to Cowan and entitled "Analogue Digital Converters". This patent is incorporated by reference. As shown in this patent, a plurality of conversion stages are cascaded together in order of significance. An analog input signal is coupled to a first conversion stage that produces a first analog residue signal and a most significant digital signal. The most significant digital signal roughly approximates the analog input signal. The first analog residue signal is produced by subtracting the most significant digital signal from the analog input signal.

The first analog residue signal is an input to a second conversion stage. The second conversion stage produces a second analog residue signal and a second most significant digital signal. The second analog residue signal is produced by subtracting the second most significant digital signal from the first analog residue signal. Together, the first and second most significant digital signals contribute to forming a digital word that is a refined approximation of the analog input signal.

As illustrated by the first and second conversion stages, each successive conversion stage operates on an analog residue signal produced by a respective preceding conversion stage. Each successive conversion stage contributes a digital signal that has less significance than digital signals produced by preceding conversion stages. As each successive conversion stage contributes a less significant digital signal to the digital word, the digital word becomes a more refined approximation of the analog input signal.

A quantizer circuit in each conversion stage comprises nine comparator amplifiers. An analog input signal is applied to the nine comparator amplifiers of the first stage along a common input line.

Each of the nine comparator amplifiers of the first stage is also coupled to a respective one of a plurality of voltage threshold references. A one volt threshold reference is coupled to the first comparator; a two volt threshold reference is coupled to the second comparator; a three volt threshold reference is coupled to the third comparator; a four volt threshold reference is coupled to the fourth comparator; a five volt threshold reference is coupled to the fifth comparator, and so on. Ultimately, a nine volt threshold reference is coupled to the ninth comparator amplifier of the first stage.

Each comparator compares the analog input signal with one of the voltage threshold references, producing an output signal indicating whether the voltage of the input signal is above or below the corresponding one voltage threshold reference. The output signals of the comparators are combined to create the most significant digital signal, roughly approximating the input signal. The most significant digital signal is subtracted from the analog input signal to produce the first residue signal. The first residue signal then serves as an input for the second conversion stage, which operates in a manner similar to that described for the first stage.

One problem with this analog to digital converter is that it is not highly linear for signals near the middle of an allowed input range. As discussed, the threshold reference voltages coupled to the comparators of the first stage range from one volt to nine volts in one volt increments. Accordingly, the allowed input range of this analog to digital converter is symmetric about a center point at the five volt threshold reference. The presence of the five volt threshold reference at this center point limits the linearity of this analog to digital converter for signals near the center point of the allowed input range. This highlights a need for a quantizer circuit that provides an analog to digital converter with improved linear response to input signals having values near the center point of the allowed input range.

### Multithreshold Comparator

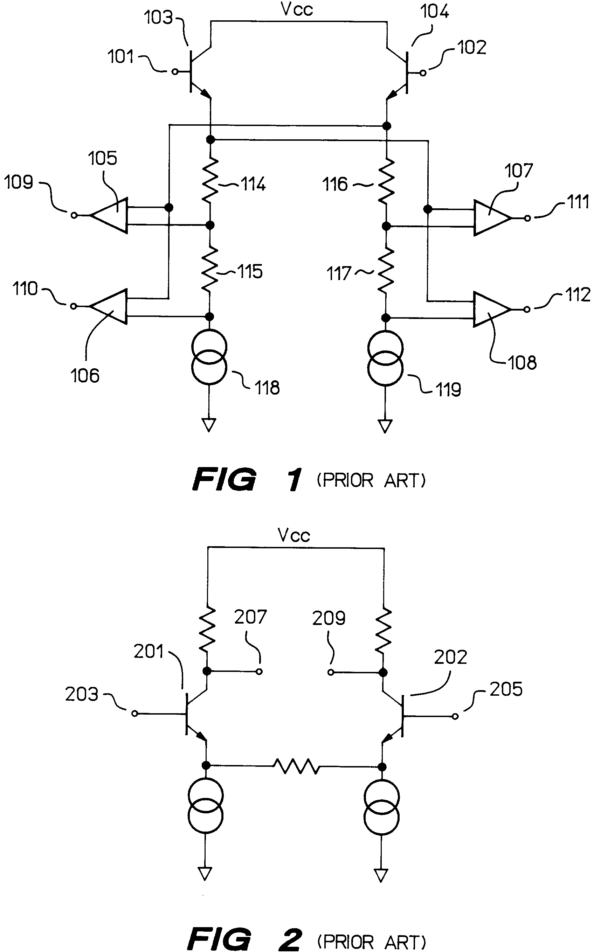

Each comparator amplifier discussed in the Cowan patent is coupled to only one voltage threshold reference. Figure 1 shows a schematic diagram of a multiple threshold differential comparator generally similar to threshold detector 114 in U.S. Patent No. 4,027,152 issued to Brown et al. entitled "Apparatus and method for transmitting binary coded data". This patent is incorporated by reference. The multiple threshold differential comparator is illustrated in Figure 1. The comparator receives an input signal from an input signal source. A positive terminal of the input signal source is coupled to a first base 101 of a first transistor 103. A negative terminal of the input signal source is coupled to a second base 102 of a second transistor 104. The first transistor is included in a first emitter follower amplifier and the second transistor is included in a second emitter follower amplifier.

A first current source 118 produces a first voltage drop V₁ across a first resistor 114 and produces a second voltage drop V₂ across a second resistor 115. A second current source 119 produces a third voltage drop V₃ across a third resistor 116 and produces a fourth voltage drop V₄ across a fourth resistor 117. A first comparator 105 compares the input signal to a threshold voltage having a positive polarity and having the magnitude of the first voltage drop V₁. The first comparator produces a first comparison signal at a first comparator output 109. A second comparator 106 compares the input signal to a threshold voltage having a positive polarity and having a magnitude corresponding to a sum of the first voltage drop V₁ and the second voltage drop V₂. The second comparator produces a second comparison signal at a second comparator output 110. A third comparator 107 compares the input signal to a threshold voltage having a negative polarity and having a magnitude of the third voltage drop V₃. The third comparator produces a third comparison signal at a third comparator output 111. A fourth comparator 108 compares the input signal to a threshold voltage having a negative polarity and having a magnitude corresponding to a sum of the third voltage drop V₃ and the fourth voltage drop V₄. The fourth comparator produces a fourth comparison signal at a fourth comparison output 112.

In some analog to digital converter applications it is desirable to dynamically vary the thresholds of the comparators. This can be done by varying current source 118 and current source 119. However, as the current from the current sources is reduced, the comparator circuit operates more slowly, due to decreased emitter follower standing currents flowing through the first transistor 103 and the second transistor 104. Also, the power dissipations of the first and second transistors vary as their respective emitter follower standing currents vary. This highlights the need for a way to keep approximately constant power dissipations and to maintain the emitter follower standing currents while varying the threshold voltages.

### Differential Amplifier

As discussed previously, the first conversion stage of the multistep analog to digital converter provides an analog residue signal as an input to the second conversion stage. It is desirable to couple the analog residue signal to the second conversion stage through a differential amplifier since differential amplifiers provide rejection of common mode noise. Figure 2 is a schematic diagram illustrating a differential amplifier circuit well known in the art of electronics.

The differential amplifier circuit is illustrated in Figure 2. The differential amplifier circuit receives a differential input signal between a first base 203 of a first signal transistor 201 and a second base 205 of a second transistor 202. A differential amplified output signal is produced between a first collector connection 207 and a second collector connection 209.

One problem with the circuit shown in Figure 2 is that nonlinear characteristics of base-emitter junctions of the first and second transistors produce nonlinear effects in the differential amplified output signal. Another problem is that normal variations in an input signal provided by the input signal source result in self heating and cooling effects in the first and second transistors. The self heating and cooling effects produce variations in emitter follower standing currents in the first and second transistors, thereby producing nonlinear frequency dependent current gain effects in the first and second transistors. Current gain of the first and second transistors typically vary with each fabrication run, further intensifying the problem of these nonlinear current gain effects. The nonlinear effects created by these problems is especially burdensome for analog to digital converters used in instrumentation applications requiring very linear performance. This highlights the need for a very linear differential amplifier for use in a multistep analog to digital converter.

It will be apparent from the foregoing that there is a need for improvements in quantizer circuits and amplifier circuits used in multistep flash analog to digital converters

### SUMMARY OF THE INVENTION

The present invention provides needed improvements in quantizer circuits and amplifier circuits for use in multistep flash analog to digital converters. A quantizer circuit of the present invention provides an analog to digital converter with an improved linear response near a center point of an allowed input range of the converter. A particular embodiment of the quantizer circuit includes a multithreshold differential comparator having improved response time while providing dynamically variable threshold levels.

The present invention provides highly linear differential amplifiers for coupling together the cascaded stages of the analog to digital converter. The highly linear differential amplifiers reject common mode noise while maintaining overall linearity of the analog to digital converter.

A reference source provides a first and second threshold signal to the quantizer circuit of the present invention, the first threshold signal having a larger value than the second threshold signal. The quantizer circuit includes a first comparison means that receives the analog input signal and the first threshold signal and that provides a first output signal. The first output signal has a first negative value if the input signal is greater than the first threshold signal.

The quantizer circuit also incudes a second comparison means that receives the analog input signal and the second threshold signal and that provides a second output signal. The second output signal has a first positive value if the input signal is lesser than the second threshold signal. A differential amplifier means sums the input signal and the two output signals to provide a residue signal for input to the subsequent conversion stage. The residue signal is an amplification of a sum of the input signal and the two output signals. The sum of the input and the two output signals is equal to the input signal if the input signal is less than the first threshold signal and greater than the second threshold signal.

The allowed input range of the analog to digital converter employing the quantizer circuit of the present invention is symmetric about a center point between the first and second threshold signals. When the input signal has a value near the center point, the effect of the quantizer circuit is simply to amplify the input signal. Accordingly, the quantizer circuit provides the analog to digital converter with improved linear response near the center point of the allowed input range of the converter. One embodiment of the present invention includes a quantizer circuit that provides the analog to digital converter with a bipolar input range symmetric about a zero center point. Rather than distorting bipolar input signals having small magnitudes near zero, the quantizer circuit provides the converter with improved linear response.

The present invention provides a novel method for linearization of the improved multistep flash analog to digital converter discussed previously.

### Improved Multithreshold Comparator

In a differential comparator providing a plurality of comparison thresholds, the present invention provides an improvement allowing dynamic variation of at least one of the plurality of thresholds while maintaining a substantially constant emitter follower standing current of an input transistor. The improvement includes a current adjustment means coupled at a first common node with the input transistor and a reference load. The current adjustment means is operative for adjusting an amount of current flowing through the reference load, thereby adjusting a voltage drop across the reference load and thereby providing dynamic variation of at least one of the plurality of comparison thresholds.

The improvement also includes a current control means and a control load. The current control means is coupled in series with the control load and the reference load. The control load is coupled to the current control means and the current adjustment means at a second common node in such a way that the emitter follower standing current of the input transistor flows through the control load means. The current control means is operative for maintaining the substantially constant emitter follower standing current.

### Improved Differential Amplifier

In a differential amplifier having a first and second signal transistors, an improvement substantially cancels any base-emitter junction nonlinearities in the first and second signal transistors. The improvement includes a first nonlinear load coupled to a collector of the first signal transistor. The first nonlinear load is operative for substantially canceling any base-emitter junction nonlinearity of the first signal transistor. Similarly, a second nonlinear load is coupled to a collector of the second signal transistor, substantially canceling any base-emitter junction nonlinearity of the second signal transistor.

In another embodiment of the present invention the nonlinear load includes a first compensating resistor and a first compensating transistor. The first compensating transistor is coupled in series with the collector of the first signal transistor. The first compensating resistor is coupled between a collector of the compensating transistor and a base of the compensating transistor. The first compensating resistor substantially cancels any variation in current gain of the first signal transistor.

Yet another embodiment of the present invention includes a bootstrap transistor coupled between the nonlinear load and the collector of the first signal transistor. A first bootstrap diode is coupled between a base of the first bootstrap transistor and a base of the first signal transistor. The first bootstrap transistor and the first bootstrap diode are operative for maintaining a collector-base voltage of the signal transistor at a substantially zero value. The first bootstrap transistor and the first bootstrap diode are operative for substantially reducing changes in self heating of the signal transistor.

Other aspects and advantages of the present invention will become apparent from the following detailed description, take in conjunction with the accompanying drawings, illustrating by way of example the principles of the invention.

### BRIEF DESCRIPTION OF THE DRAWINGS

Figure 1 shows a multithreshold differential comparator of the prior art.

Figure 2 shows a differential amplifier of the prior art.

Figure 3 shows a block diagram illustrating one embodiment of the multistep flash analog to digital converter of the present invention.

Figure 4 shows a block diagram illustrating a preferred embodiment of the first quantizer circuit shown in Figure 3.

Figure 5 shows a schematic diagram illustrating a preferred embodiment of portions of the first quantizer circuit shown in Figure 4.

Figure 6 shows a block diagram illustrating an alternative embodiment of the first quantizer circuit shown in Figure 3.

Figure 7 shows a partial schematic, partial block diagram of portions of the first quantizer circuit shown in Figure 6.

Figure 8 shows a schematic diagram illustrating one embodiment of the multithreshold differential comparator of the present invention.

Figure 9 shows a schematic diagram illustrating one embodiment of the differential amplifier of the present invention.

Figure 10 shows a schematic diagram illustrating another embodiment of the differential amplifier of the present invention.

Figure 11 shows a schematic diagram illustrating a preferred embodiment of the differential amplifier of the present invention.

Figure 12 shows a flowchart illustraing an embodiment of a novel method for linearization of the multistep flash analog to digital converter of the present invention.

### DETAILED DESCRIPTION OF THE INVENTION

As shown in the drawings for purposes of illustration, the invention is embodied in a multistep flash analog to digital converter.

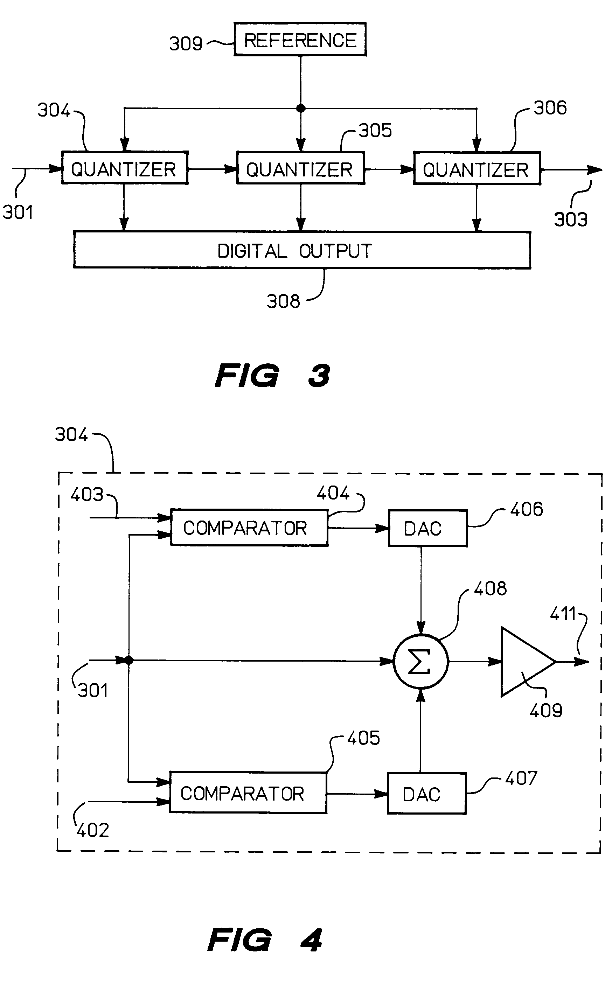

Figure 3 shows a block diagram illustrating an embodiment of a multistep flash analog to digital converter having a plurality of conversion stages, each conversion stage including a quantizer circuit of the present invention. The analog to digital converter shown in Figure 3 receives an analog input signal at an analog input 301 of a first quantizer circuit 304. The input signal has a magnitude and a polarity. The first quantizer circuit 304 produces a first analog residue signal as well as a most significant digital signal roughly approximating the analog input signal.

The second quantizer circuit 305 is coupled to a first quantizer circuit 304 so as to receive the first analog residue signal from the first quantizer circuit. The second quantizer circuit produces a second analog residue signal and a second most significant digital signal. A third quantizer circuit 306 is coupled to the second quantizer circuit 305 so as to receive the second analog residue signal. The third quantizer circuit produces a third analog residue signal and a least significant digital signal.

A digital output circuit 308 is coupled to the first, second and third quantizer circuits so as to receive the most significant digital signal, the second most significant digital signal, and the least significant digital signal. The digital output circuit decodes these digital signals and produces a signed digital word approximating the magnitude and polarity of the analog input signal.

Each of the three quantizer circuits is coupled to a reference source 309 so that each quantizer circuit receives a first and a second threshold signal. As will be discussed in more detail, the first and second signals are used by each quantizer circuit in producing the respective residue signals and digital signals.

Though the embodiment of the multistep flash analog to digital converter of the present invention shown in Figure 3 includes the first, second and third quantizer circuits, the present invention is not strictly limited to three quantizer circuits cascaded together. In alternative embodiments, the invention may be practiced with fewer than three quantizer circuits cascaded together, or with more than three quantizer circuits cascaded together. In a preferred embodiment, each of the quantizer circuits of the analog to digital converter has a similar architecture. For this reason, further illustration of the first quantizer circuit 304 will also serve as further illustration of the second quantizer circuit 305 and the third quantizer circuit 306.

Figure 4 is a block diagram illustrating a preferred embodiment of the first quantizer circuit 304. The first quantizer circuit receives the analog input signal at the analog input 301. As shown, a first comparator 404 and a second comparator 405 each receive the analog input signal. The first comparator 404 receives the first threshold signal at a first reference input 403. The second comparator 405 receives the second threshold signal at a second reference input 402. The first threshold signal has a larger value than the second threshold signal. Accordingly, in the preferred embodiment, the first threshold signal has a magnitude equal to that of the second threshold signal, but the first threshold signal has a positive polarity while the second threshold signal has a negative polarity. In the preferred embodiment the first quantizer circuit provides the analog to digital converter with a bipolar input range symmetric about a zero center point.

The first comparator 404 compares the input signal to the first threshold signal to produce a first comparison signal. The first comparison signal is received by a first digital to analog converter (DAC) 406 to produce a first output signal. When the input signal is above the first threshold signal, the first output signal has a first negative value.

Similarly, the second comparator 405 compares the input signal to the second threshold signal to produce a second comparison signal. Together, the second comparison signal and the first comparison signal form the most significant digital signal that is received and decoded by the digital output 308, as discussed previously. The second comparison signal is received by a second digital to analog converter (DAC) 407 to produce a second output signal. When the input signal is below the second threshold signal, the second output signal has a first positive value.

As shown in figure 4, a summer 408 receives the input signal and the first and second output signals so as to produce a sum of the input signal and the first and second output signals. The amplifier receives the sum of the input signal and the first and second output signals so as to produce a first residue signal at an output 411, for input to the second quantizer circuit 305. The residue signal is an amplification of the sum of the input signal and the two output signals. In the preferred embodiment, the amplifier produces the first residue signal by doubling the sum of the input signal and the two output signals. The sum of the input and the two output signals is equal to the input signal if the input signal is less than the first threshold signal, and greater than the second threshold signal.

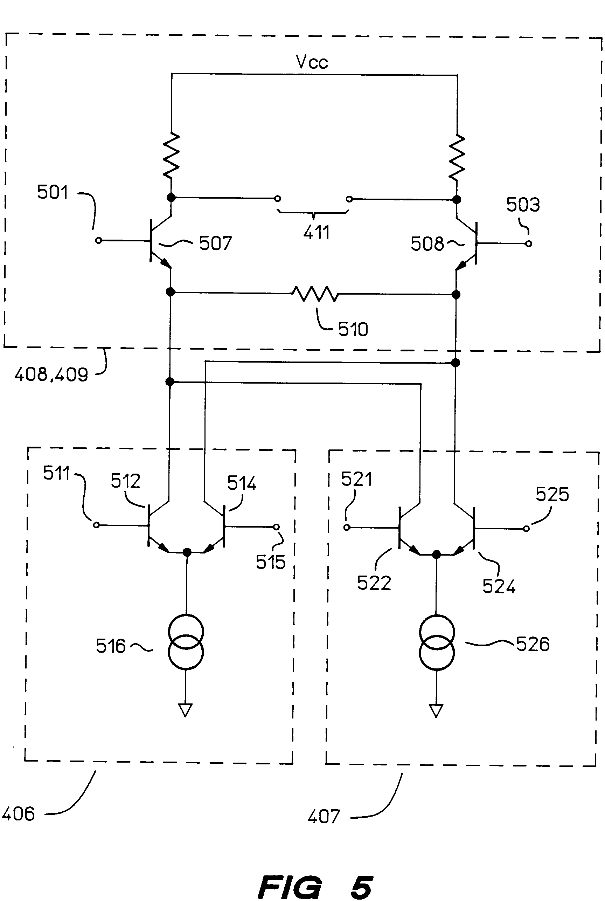

Figure 5 is a schematic diagram illustrating a preferred embodiment of the summer 408 and differential amplifier 409. Embodiments of the first digital to analog converter 406 and the second analog to digital converter are also shown. A first signal transistor 507 and a second signal transistor 508 are coupled to a common load 510 so as to form the differential amplifier. The analog input signal is coupled across a first and a second differential signal input 501, 503. The first residue signal is produced across an output 411. The function of the summer 408 shown in the block diagram of Figure 4 is implemented across common load 510.

The first digital to analog converter 406 includes a first pair of transistors 512, 514, that are each emitter coupled to a first current source 516. The first comparison signal is applied across a first pair of comparison inputs 511, 515. The first digital to analog converter is coupled in parallel across the common load 510 so as to produce the first output signal across the common load.

Similarly, the second digital to analog converter 407 includes a second pair of transistors 522, 524, that are each emitter coupled to a second current source 526. The second comparison signal is applied between the second pair of comparison inputs 521, 525. The second digital to analog converter is coupled in parallel across the common load 510 so as to produce the second output signal across the common load.

In the preferred embodiment, the first output signal has a second positive value if the input signal is less than the first threshold signal, and the second output signal has a second negative value if the input signal is greater than the second threshold signal. The second positive value is equal in magnitude to the second negative value, so that if the first output signal has the second positive value and the second output signal has the second negative value, then the two output signals cancel each other when they are summed at the common load. Accordingly, the sum of the input and the two output signals is equal to the input signal if the input signal is less than the first threshold signal and greater than the second threshold signal.

In the preferred embodiment, the first and second output signals each have the first negative value if the input signal is greater than the first threshold signal. Similarly, the first and second output signals each have the first positive value if the input signal is less than the second threshold signal. In both these cases, the first and second output signals add together in the common load to reinforce each other rather than cancel each other. In the preferred embodiment the first positive value is the same as that of the first threshold signal, and the first negative value is the same as that of the second threshold signal.

In some alternative embodiments, the first output signal has a zero value if the input signal is less than the first threshold signal, and the second output signal has the zero value if the input signal is greater than the second threshold signal. Once again, the sum of the input and the two output signals is equal to the input signal if the input signal is less than the first threshold signal and greater than the second threshold signal. Correspondingly, in some alternative embodiments the first positive value is equal to twice that of the first threshold signal and the first negative is equal to twice that of the second threshold signal.

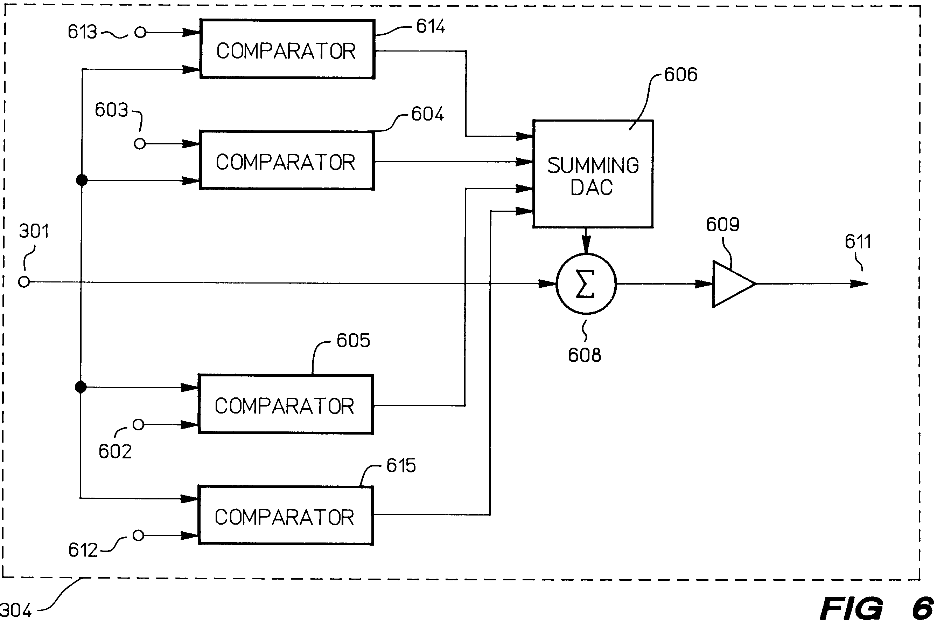

Figure 6 is a block diagram illustrating another alternative embodiment of the first quantizer circuit 304. The first quantizer circuit receives the analog input signal at the analog input 301. A first comparator 604, a second comparator 605, a third comparator 614, and a fourth comparator 615 each receive the analog input signal. The first comparator 604 receives the first threshold signal at a first reference input 603. The second comparator 605 receives the second threshold signal at a second reference input 602.

In the alternative embodiment, the reference source further provides a third threshold signal and a fourth reference signal in addition to the first and second threshold signals discussed previously. The third comparator 614 receives the third threshold signal at a third reference input 613. The fourth comparator 615 receives the fourth threshold signal at a fourth reference input 612.

In the alternative embodiment, the first threshold signal has a magnitude equal to that of the second threshold signal, but the first threshold signal has a positive polarity while the second threshold signal has a negative polarity. Similarly, the third threshold signal has a magnitude equal to that of the fourth threshold signal, but the third threshold signal has the positive polarity while the fourth threshold has the negative polarity. The third threshold signal has a larger value than the first threshold signal. Accordingly, the first quantizer circuit provides the analog to digital converter with a bipolar input range symmetric about a zero center point.

The first comparator 604 compares the input signal to the first threshold signal to produce a first output signal. Similarly, the second, third, and fourth comparators respectively compare the input signal to the second, third, and fourth threshold signals to respectively produce a second, third, and fourth output signals. In the alternative embodiment, the first, second, third, and fourth output signals together form the most significant digital signal that is received and decoded by the digital output 308 discussed previously. The first, second, third, and fourth output signals are received by a summing digital to analog converter 606. In the alternative embodiment the summing digital to analog converter produces a sum of the first, second, third, and fourth output signals.

As shown in figure 6, a summer 608 sums the input signal and the sum of the first, second, third, and fourth output signals. A first residue signal is produced at an output 611 of differential amplifier 609 for input to the second quantizer circuit 305. The residue signal is an amplification of a sum of the input signal and the sum of the first, second, third, and fourth output signals.

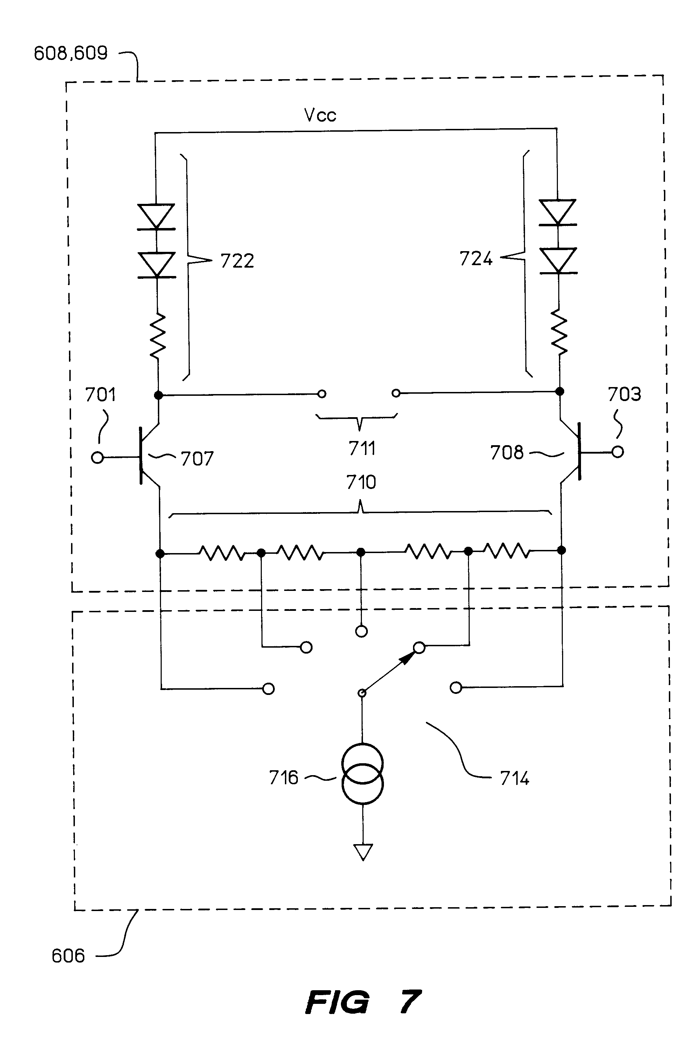

Figure 7 is a partial schematic, partial block diagram showing embodiments of the summing digital to analog converter 606, the differential amplifier 609, and the summer 608. A first signal transistor 707 and a second signal transistor 708 are coupled to a common load 710 so as to form the differential amplifier. The analog input signal is coupled across a first and second differential signal inputs 701, 703. A first nonlinear load 722 is coupled to a collector of the first signal transistor 707. A second nonlinear load is coupled to a collector of the second signal transistor 708. The operation of the first and second nonlinear loads is discussed in greater detail later when improvements to the differential amplifier are addressed. The first residue signal is produced across an output 711. The summer 408 is implemented across common load 710. The common load has a plurality of resistor taps.

The summing digital to analog converter 606 includes a current source 716 and a switching means 714. The switching means is coupled between the current source and the plurality of resistor taps. The switching is responsive the sum of the first, second, third, and fourth output signals so as to selectively connect the current source one of the plurality of resistor taps, effectively summing the first, second, third and fourth output signals with the input signal.

In the alternative embodiment, the first output signal has a first negative value if the input signal greater than the first threshold signal, and has a zero value if the input signal is less than the first threshold signal. The second output signal has a first positive value if the input signal is less than the second threshold signal, and has the zero value if the input signal is greater than the second threshold value. The third output signal has the first negative value if the input signal is greater than the third threshold signal, and has the zero value if the input signal is less than the third threshold value. The fourth output signal has the first positive value if the input signal is less than the fourth threshold signal, and has the zero value if the input signal is greater than the fourth threshold signal.

### Linearization Method

The present invention provides a novel method for linearization of the multistep flash analog to digital converter discussed previously. The analog to digital converter produces a signed digital word corresponding to the polarity and the magnitude of the input signal. The initial conversion stage of the analog to digital converter includes the improved quantizer circuit discussed previously. The subsequent conversion stage of the analog to digital converter has a contribution to the signed digital word that includes a least significant bit of the signed digital word.

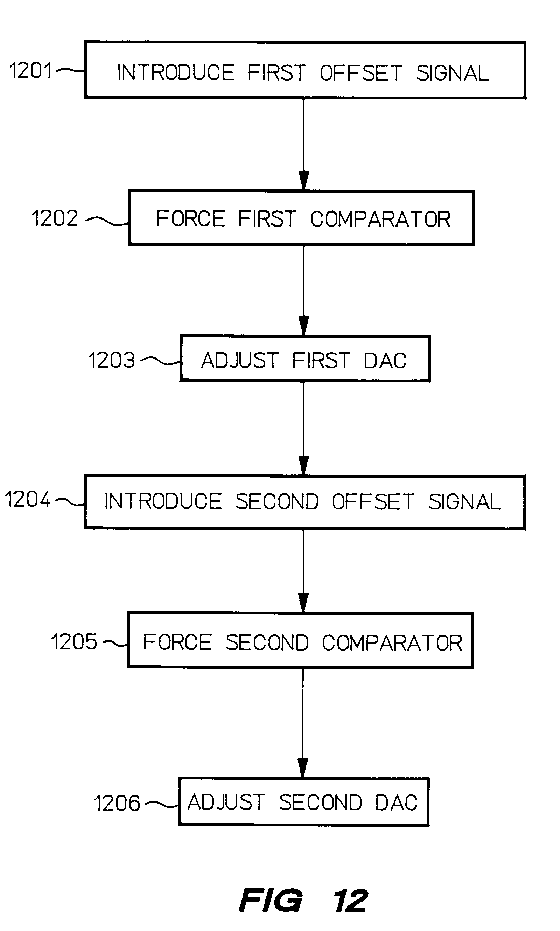

An embodiment of the linearization method is illustrated by the flowchart shown in Figure 12. As an initial step 1201 of the linearization method, a first offset signal is introduced as the analog input signal to the analog to digital converter. The first offset signal has a magnitude and a polarity such that the first offset signal would cause the analog to digital converter to produce a digital word having a value of +1 least significant bit during normal operation.

During normal operation of the analog to digital converter, the first comparator of the initial stage would recognize the first offset signal as being below the first threshold signal. However, as a second step 1202 of the linearization method, control is exerted over circuitry of the first comparator so as to force the first comparator to recognize the first offset signal as being above the first threshold signal. Accordingly, the first output signal of the initial stage is caused to have the first negative value.

As a third step 1203 of the linearization method, circuitry the first digital to analog converter (DAC) of the initial stage is adjusted so that the final stage produces a residue output that has a substantially zero value.

As a fourth step 1204 of the linearization method, the first offset signal is replaced with a second offset signal. Accordingly, the second offset signal is introduced as the analog input signal to the analog to digital converter. The second offset signal has a magnitude and a polarity such that the second offset signal would cause the analog to digital converter to produce a digital word having a value of -1 least significant bit during normal operation.

During normal operation of the analog to digital converter, the second comparator of the initial stage would recognize the second offset signal as being above the second threshold signal. However, as a fifth step 1205 of the linearization method, control is exerted over circuitry of the second comparator so as to force the second comparator to recognize the second offset signal as being below the second threshold signal. Accordingly, the second output signal of the initial stage is caused to have the first positive value.

As a sixth step 1206 of the linearization method, circuitry of the second digital to analog converter (DAC) of the initial stage is adjusted so that the final stage produces a residue output that has a substantially zero value.

### Improved Multithreshold Comparator

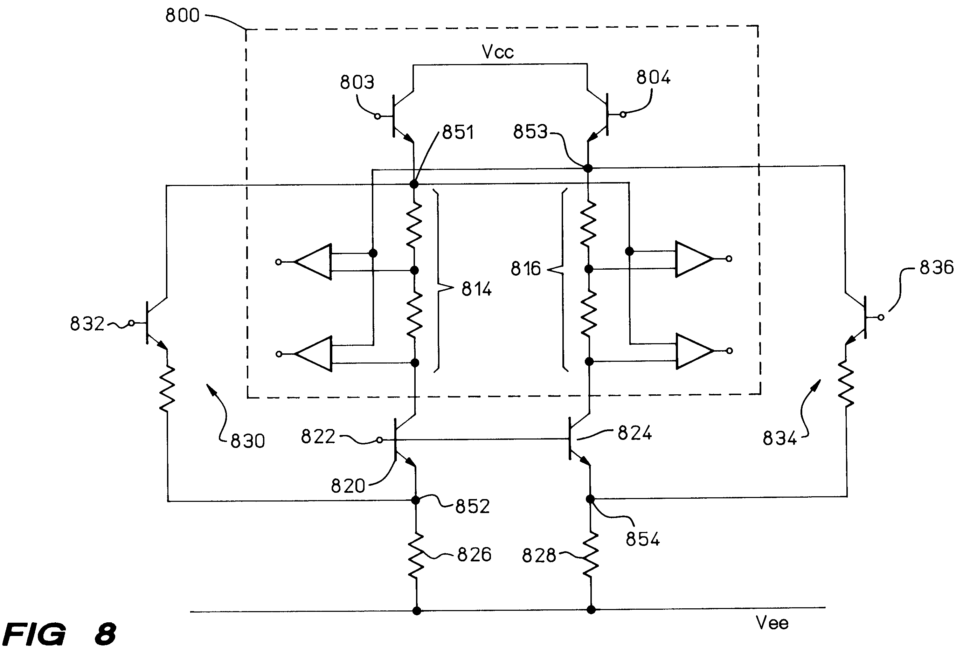

In a differential comparator providing a plurality of comparison thresholds, an improvement of the present invention provides dynamic variation of at least one of the plurality of thresholds while maintaining a substantially constant emitter follower standing current of a first input transistor. Figure 8 shows an embodiment of an improved comparator. Those with ordinary skill in the art of electronics will recognize a portion 800 of the improved comparator that is generally similar to the multithreshold comparator discussed in detail in the background of the invention.

The improved comparator further includes a first current adjustment means 830 coupled at a first common node 851 with the first input transistor 803 and a series coupled first and second reference resistor 814. The first current adjustment means receives a first adjustment signal at a first adjustment input 832. The first current adjustment means is responsive to the first adjustment signal so as to adjust a first amount of current flowing through the series coupled first and second reference loads, thereby adjusting a voltage drop across the series coupled first and second reference resistor and thereby providing dynamic variation of at least one of the plurality of comparison thresholds.

The improved comparator includes a first current control means 820 and a first control load 826. The first current control means is coupled in series with the first control load 826 and the series coupled first and second reference resistor. The first control load is coupled to the first current control means and the first current adjustment means at a second common node 852 in such a way that the emitter follower standing current of the first input transistor flows through the control load. The first current control means receives a current control signal at control signal input 822. The first current control means is responsive to the current control signal so as to maintain the substantially constant emitter follower standing current of the first input transistor.

The improved comparator further includes a second current adjustment means 834 coupled at a third common node 853 with a second input transistor 804 and a series coupled third and fourth reference loads 816. The second current adjustment means receives a second adjustment signal at a second adjustment input 836. The second current adjustment means is responsive to the second adjustment signal so as to adjust a second amount of current flowing through the series coupled third and fourth reference loads, thereby adjusting a voltage drop across the series coupled third and fourth reference loads.

The improved comparator includes a second current control means 824 and a second control load 828. The second current control means is coupled in series with the second control load and the series coupled third and fourth reference loads. The second control load is coupled to the second current control means and the second current adjustment means at a fourth common node 854 in such a way that an emitter follower standing current of the second input transistor flows through the second control load. The second current control means receives the current control signal at the control signal input 822. The second current control means is responsive to the current control signal so as to maintain the emitter follower standing current of the second input transistor substantially constant.

### Improved Differential Amplifier

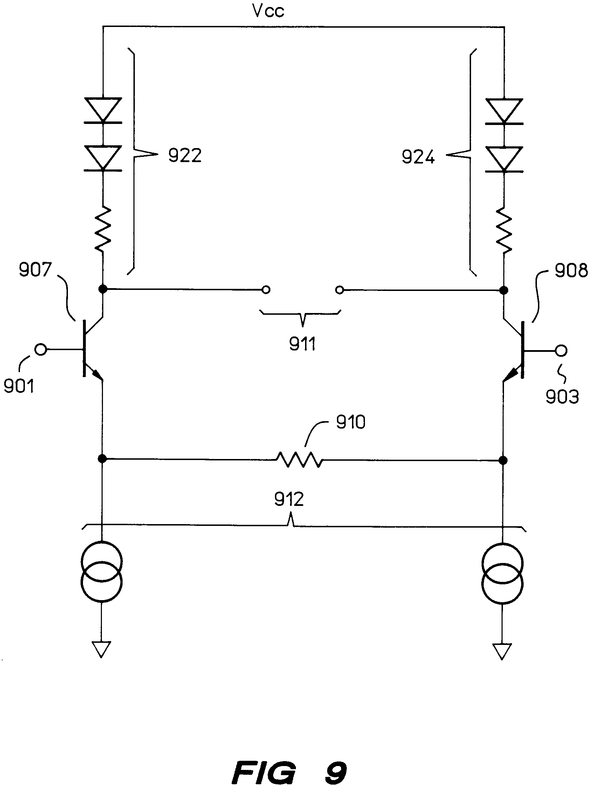

In a differential amplifier having a first and second signal transistor, an improvement of the present invention substantially cancels any base-emitter junction nonlinearities in the first and second transistors. Figure 9 shows an embodiment of an improved differential amplifier. The improvement includes a first nonlinear load 922 coupled to a collector of the first transistor 907. The first nonlinear load includes a first pair of diodes and a first resistor coupled together in series. The first nonlinear load substantially cancels any base-emitter junction nonlinearity of the first transistor. Similarly, a second nonlinear load 924 is coupled to a collector of the second transistor. The second nonlinear load includes a second pair of diodes and a second resistor coupled together in series and is operative for substantially canceling any base-emitter junction nonlinearity of the second transistor. A common load 910 is coupled between respective emitters of the first and second signal transistors. A current control means 912 is coupled to the emitters of the first and second signal transistors. The differential amplifier receives a differential input signal between a first input 901 and a second input 903. The differential amplifier produces an amplified differential output signal between a pair of output connectors 911.

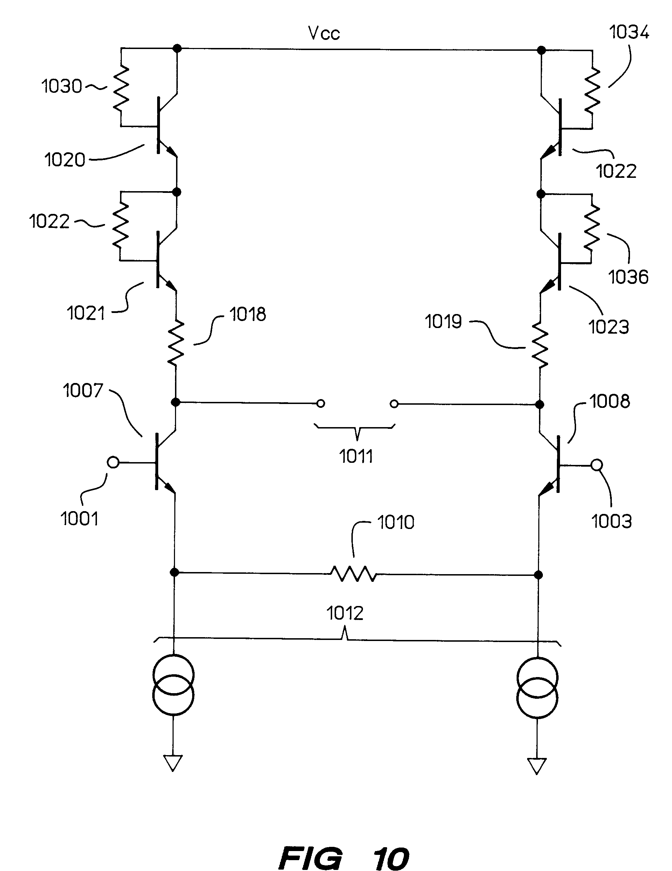

Another embodiment of the improved differential amplifier is shown in figure 10. A first compensating transistor 1021, a second compensating transistor 1020, and a first collector resistor 1018 are coupled together in series with a collector of a first signal transistor 1007. The first and second compensating transistors are each substantially cancel any base-emitter junction nonlinearity of the first signal transistor.

A first compensating resistor 1032 is coupled between a collector of the first compensating transistor and a base of the first compensating transistor. A second compensating resistor 1030 is coupled between a collector of the second compensating transistor and a base of the second compensating transistor. The first and second compensating resistors are each operative for substantially canceling any variation in current gain of the first signal transistor.

Similarly, a third compensating transistor 1023, a second compensating transistor 1022, and a second collector resistor 1019 are coupled together in series with a collector of a second signal transistor 1008. The first and second compensating transistors are each operative for substantially canceling any base-emitter junction nonlinearity of the second signal transistor.

A third compensating resistor 1036 is coupled between a collector of the third compensating transistor and a base of the third compensating transistor. A fourth compensating resistor 1034 is coupled between a collector of the fourth compensating transistor and a base of the fourth compensating transistor. The third and fourth compensating resistors are each operative for substantially canceling any variation in current gain of the second signal transistor.

A common load 1010 is coupled between respective emitters of the first and second signal transistors. A current control means 1012 is coupled to the emitters of the first and second signal transistors. The differential amplifier receives a differential input signal between a first input 1001 and a second input 1003. The differential amplifier produces a differential amplified output signal between a pair of output connectors 1011.

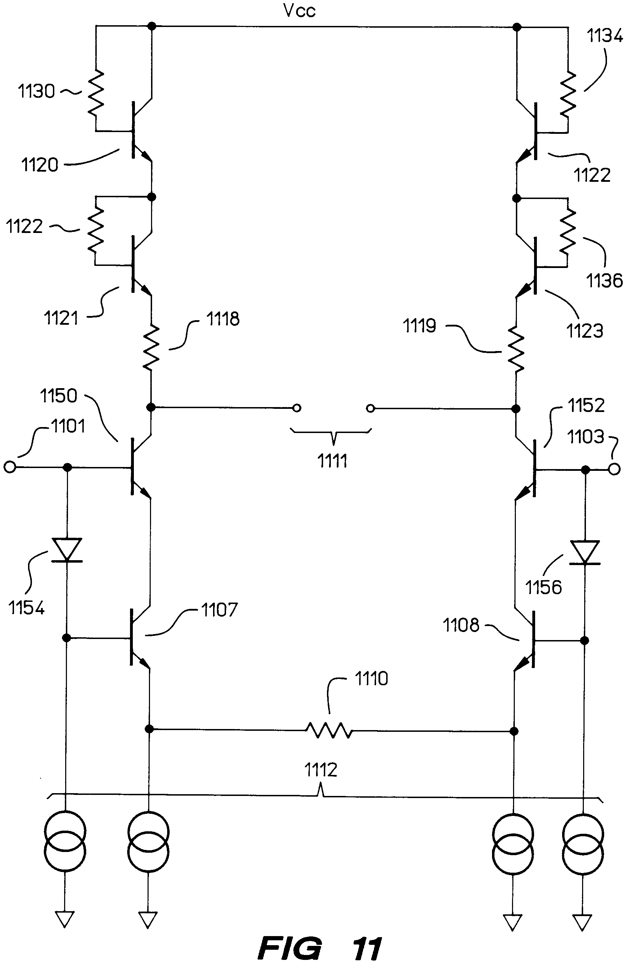

A preferred embodiment of the improved differential amplifier is shown in figure 11. A first bootstrap transistor 1150 is coupled between a first nonlinear load and a collector of a first signal transistor 1107. A first bootstrap diode 1154 is coupled between a base of the first bootstrap transistor and a base of the first signal transistor. The first bootstrap transistor and the first bootstrap diode are operative for maintaining a collector-base voltage of the first signal transistor at a substantially zero value. The first bootstrap transistor and the first bootstrap diode are operative for substantially reducing changes in self heating of the first signal transistor.

As shown in figure 11, the first nonlinear load includes a first compensating transistor 1121, a second compensating transistor 1120, and a first collector resistor 1118 coupled together in series. The first and second compensating transistors are each operative for substantially canceling any base-emitter junction nonlinearity of the first signal transistor.

A first compensating resistor 1132 is coupled between a collector of the first compensating transistor and a base of the first compensating transistor. A second compensating resistor 1130 is coupled between a collector of the second compensating transistor and a base of the second compensating transistor. The first and second compensating resistors are each operative for substantially canceling any variation in current gain of the first signal transistor.

A second bootstrap transistor 1152 is coupled between a second nonlinear load and a collector of a second signal transistor 1108. A second bootstrap diode 1156 is coupled between a base of the second bootstrap transistor and a base of the second signal transistor. The second bootstrap transistor and the second bootstrap diode are operative for maintaining a collector-base voltage of the second signal transistor at the substantially zero value. The second bootstrap transistor and the second bootstrap diode are operative for substantially reducing changes in self heating of the second signal transistor.

The second nonlinear load includes a third compensating transistor 1123, a fourth compensating transistor 1122, and a second collector resistor 1119 coupled together in series. The third and fourth compensating transistors are each operative for substantially canceling any base-emitter junction nonlinearity of the first signal transistor.

A third compensating resistor 1136 is coupled between a collector of the third compensating transistor and a base of the third compensating transistor. A fourth compensating resistor 1134 is coupled between a collector of the fourth compensating transistor and a base of the fourth compensating transistor. The third and fourth compensating resistors are each operative for substantially canceling any variation in current gain of the second signal transistor.

It is desirable to construct the first and second compensating transistors so that each are operative to reduce small changes in self heating of the first signal transistor caused by variations in the input signal. Similarly, it is desirable to construct the third and fourth compensating transistors so that each are operative to reduce small changes in self heating of the second signal transistor caused by variations in the input signal. One step toward achieving the desired results is to construct the first and second compensating transistors each to have a power density approximately equal to that of the first signal transistor. Similarly, the third and fourth compensating transistors are constructed to have a power density approximately equal to that of the second signal transistor.

Another step toward achieving the desired results is to construct the respective transistors so that they are thermally coupled. Specifically, the first, second, third, and fourth compensating transistors and the first and second signal transistors are all fabricated together on a monolithic substrate in such a way that the first and second compensating transistors and the first signal transistor all have a first common centroid, and in such a way that the third and fourth compensating transistors and the second signal transistor all have a second common centroid. Accordingly, small changes in self heating of the first signal transistor caused by variations in the input signal are correlated with small changes in self heating of the first and second compensating transistors. Small changes in self heating of the second signal transistor caused by variations in the input signal are correlated with small changes in self heating of the third and fourth compensating transistors. The present invention embodies these teachings so that the first and second compensating transistors are each operative to reduce small changes in self heating of the first signal transistor caused by variations in the input signal. Similarly, the third and fourth compensating transistors are each operative to reduce small changes in self heating of the second signal transistor caused by variations in the input signal.

A common load 1110 is coupled between respective emitters of the first and second signal transistors. A current control means 1112 is coupled to the emitters of the first and second signal transistors. The differential amplifier receives an input signal between a first input 1101 and a second input 1103. The differential amplifier produces an output signal between a pair of output connectors 1111.

Although specific embodiments of the present invention have been described and illustrated, the invention is not to be limited to the specific forms or arrangements of parts so described and illustrated, and various modifications and changes can be made without departing from the scope and spirit of the invention. Within the scope of the appended claims, therefore, the invention may be practiced otherwise than as specifically described and illustrated.

## Claims

1. In a multistep flash analog-to-digital converter including an initial conversion stage, a subsequent conversion stage and a reference source, the reference source providing a first and second threshold signals such that the first threshold signal has a larger value then the second threshold signal, an apparatus for quantizing an analog input signal, the apparatus comprising:
a first comparison means (404, 406; 604, 606) that receives the analog input signal (301) and the first threshold signal (403; 603) and that provides a first output signal, the first output signal having a first negative value if the input signal is greater than the first threshold signal;
a second comparison means (405, 407; 605, 606) that receives the analog input signal and the second threshold signal and that provides a second output signal, the second output signal having a first positive value if the input signal is lesser than the second threshold signal; and
a summing means (408, 409; 606, 608, 609) for summing the input signal and the two output signals to provide an analog residue signal (411; 611) for input to the subsequent conversion stage.

2. An apparatus as in claim 1 wherein;
the first output signal has a zero value if the input signal is less than the first threshold signal; and
the second output signal has the zero value if the input signal is greater than the second threshold signal.

3. An apparatus as in claim 1 wherein the summing means (408, 409; 606, 608, 609) includes a differential amplifier means (409; 609) that sums the input signal (301) and the two output signals to provide the residue signal (411; 611), the residue signal being an amplification of a sum of the input signal and the two output signals.

4. An apparatus as in claim 3 wherein the differential amplifier means (409; 609) includes a common load means (510; 710) and a first and a second signal transistor (507, 508; 707, 708), the common load means being coupled between an emitter of the first signal transistor and an emitter of the second signal transistor, the input signal being coupled between a base of the first transistor and a base of the second transistor, the residue signal (411; 711) being produced between a collector of the first signal transistor and a collector of the second signal transistor.

5. An apparatus as in claim 4 wherein:
the common load means (710) has a plurality of resistor taps; and
the summing means further includes a current source (716) and a switching means (714); the switching means being coupled between the current source and the plurality of resistor taps; the switching means (714) being responsive to a sum of the first and second output signals so as to selectively connect the current source (716) to one of the plurality of resistor taps, thereby summing the first and second output signals with the input signal.

6. An apparatus as in claim 1 wherein the first comparision means (404; 604) includes a multithreshold differential comparator that provides dynamic variation of at least one of a plurality of thresholds while maintaining a substantially constant emitter follower standing current of an input transistor (803) of the comparator, the comparator including:
a current adjustment means (830); the current adjustment means being coupled at a first common node (851) with the input transistor (803) and a reference load (814); the current adjustment means (830) being operative for adjusting an amount of current flowing through the reference load (814), thereby adjusting a voltage drop across the reference load (814) and thereby providing dynamic variation of at least one of the plurality of comparison thresholds; and
a current control means (820) and a control load (826); the current control means (820) being coupled in series with the control load (826) and the reference load (814); the control load means (826) being coupled to the current control means (820) and the current adjustment means (830) at a second common node (852) in such a way that the emitter follower standing current of the input transistor (803) flows through the control load (826); the current control means being operative for maintaining the substantially constant emitter follower standing current.

7. In a differential amplifier having a first and second signal transistor (907, 908; 1007, 1008; 1107, 1108), an improvement substantially canceling any base-emitter junction nonlinearities in the first and second transistor, the improvement comprising:
a first nonlinear load (922; 1030, 1020, 1032, 1021, 1018; 1130, 1120, 1132, 1121, 1118) coupled to a collector of the first transistor (907; 1007); the first nonlinear load being operative for substantially canceling any base-emitter junction nonlinearity of the first transistor; and
a second nonlinear load (924; 1034, 1022, 1036, 1023, 1019; 1134, 1122, 1136, 1123, 1119) coupled to a collector of the second transistor (908; 1008; 1108); the first nonlinear load being operative for substantially canceling base-emitter junction nonlinearity of the second transistor.

8. The improvement of claim 7 wherein the first nonlinear load means includes:
first compensating transistor (1021; 1121) coupled in series with the collector of the first signal transistor (1007; 1107); and
a first compensating resistor (1018, 1118); the first compensating resistor being coupled between a collector of the compensating transistor and a base of the compensating transistor; the first compensating resistor being operative for substantially canceling any variation in current gain of the first signal transistor.

9. The improvement of claim 8 wherein the first compensating transistor has a power density approximately equal to that of the first signal transistor.

10. The improvement of claim 7 further comprising:
a first bootstrap transistor (1150) coupled between the nonlinear load and the collector of the first signal transistor; and
a first bootstrap diode (1154) coupled between a base of the bootstrap transistor and a base of the signal transistor; the bootstrap transistor and diode being operative for maintaining a collector-base voltage of the signal transistor at a substantially zero value, the bootstrap transistor and diode being operative for substantially reducing changes in self heating of the transistor.
